(19) Europäisches Patentamt / European Patent Office / Office européen des brevets

(11) **EP 3 158 644 B1**

(12) **EUROPEAN PATENT SPECIFICATION**

(45) Date of publication and mention
of the grant of the patent:
**10.01.2024   Bulletin 2024/02**

(21) Application number: **15809066.2**

(22) Date of filing: **08.06.2015**

(51) International Patent Classification (IPC):
*H04L 27/00* (2006.01)    *H03L 1/02* (2006.01)
*H03H 3/007* (2006.01)    *H03H 3/013* (2006.01)
*H03J 3/04* (2006.01)    *H03B 5/04* (2006.01)
*H03B 5/36* (2006.01)

(52) Cooperative Patent Classification (CPC):
**H03B 5/04; H03B 5/368; H03J 3/04; H03L 1/025;
H03L 1/028;** H04L 2027/0016

(86) International application number:
**PCT/FI2015/050395**

(87) International publication number:
**WO 2015/193539 (23.12.2015 Gazette 2015/51)**

(54) **METHOD AND INTEGRATED CIRCUIT FOR TEMPERATURE COMPENSATION OF OSCILLATOR, AND TEMPERATURE-COMPENSATED OSCILLATOR UNIT**

VERFAHREN UND INTEGRIERTE SCHALTUNG ZUR TEMPERATURKOMPENSATION EINES OSZILLATORS UND TEMPERATURKOMPENSIERTE OSZILLATOREINHEIT

PROCÉDÉ ET CIRCUIT INTÉGRÉ POUR COMPENSATION DE TEMPÉRATURE D'OSCILLATEUR, ET UNITÉ À OSCILLATEUR À TEMPÉRATURE COMPENSÉE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **18.06.2014  FI 20145586**

(43) Date of publication of application:
**26.04.2017   Bulletin 2017/17**

(73) Proprietor: **Micro Analog Systems Oy
00380 Helsinki (FI)**

(72) Inventors:
• **LIGNELL, Eero
   00380 Helsinki (FI)**
• **OLL, Jaak
   00380 Helsinki (FI)**

(74) Representative: **Kolster Oy Ab
(Salmisaarenaukio 1)
P.O. Box 204
00181 Helsinki (FI)**

(56) References cited:
WO-A1-2013/023068    CN-U- 203 206 191
US-A- 5 500 618    US-A- 5 742 741
US-A- 6 002 291    US-A1- 2002 105 362
US-A1- 2002 105 362    US-A1- 2005 128 018
US-A1- 2006 132 254    US-A1- 2006 132 254
US-A1- 2013 041 859    US-B1- 6 484 133

• CONTI M ET AL: "A current driven, programmable gain differential pair using MOS translinear circuits", CIRCUITS AND SYSTEMS, 1998. ISCAS '98. PROCEEDINGS OF THE 1998 IEEE IN TERNATIONAL SYMPOSIUM ON MONTEREY, CA, USA 31 MAY-3 JUNE 1998, NEW YORK, NY, USA,IEEE, US, vol. 1, 31 May 1998 (1998-05-31), pages 543-546, XP010289647, DOI: 10.1109/ISCAS.1998.704566 ISBN: 978-0-7803-4455-6

## Description

### Field of the invention

The invention relates in general to electronic oscillation generators and to the stabilization of electronic oscillation generators, and especially to temperature-compensated oscillator units used in electronics and telecommunications technology, for example, as well as to a method and integrated circuit for temperature compensation of oscillators.

### Background of the invention

Oscillators are widely used in electronics and telecommunications technology as very stable and precise frequency sources. Oscillators include crystal oscillators or micromechanical oscillators, so-called MEMS oscillators (MEMS, Micro Electro Mechanical Systems). In a voltage-controlled crystal oscillator (VCXO), the nominal oscillation frequency is adjustable in response to voltage control input. The frequency precision of crystal oscillators are influenced by many variables, such as temperature, aging, control level, monitoring, and vibration. The quartz crystal of a conventional crystal oscillator has rather extensive temperature variations that depend on the cutting angle of the quartz crystal.

In many applications, requirements for the greatest temperature variations are much stricter than this variation in a conventional quartz crystal, and, therefore, various temperature-compensation methods have been developed. One way of achieving temperature stability is to thermally insulate the crystal and oscillator circuit from the changes in the ambient temperature. In an oven-controlled crystal oscillator (OCXO), the crystal and other temperature-sensitive components are in a stable oven (a small, isolated cladding usually made of metal), which is equipped with a heating element and control mechanism for adjusting focused heat so as to maintain an increased constant temperature. However, oven-controlled crystal oscillators have drawbacks, such as the space required by the oven.

A temperature-compensated crystal oscillator (TCXO) and a voltage-controlled temperature-compensated crystal oscillator (VCTCXO) typically contain a temperature-compensation circuit for measuring ambient temperature and adjusting crystal frequency so as to prevent a frequency shift in the temperature area.

The prior art will be described in the following in greater detail with reference to the accompanying figures, in which:

Figure 1 shows a set of frequency-temperature curves of an AT-cut crystal according to the prior art,
Figure 2 shows a prior-art integrated circuit for oscillator temperature compensation.

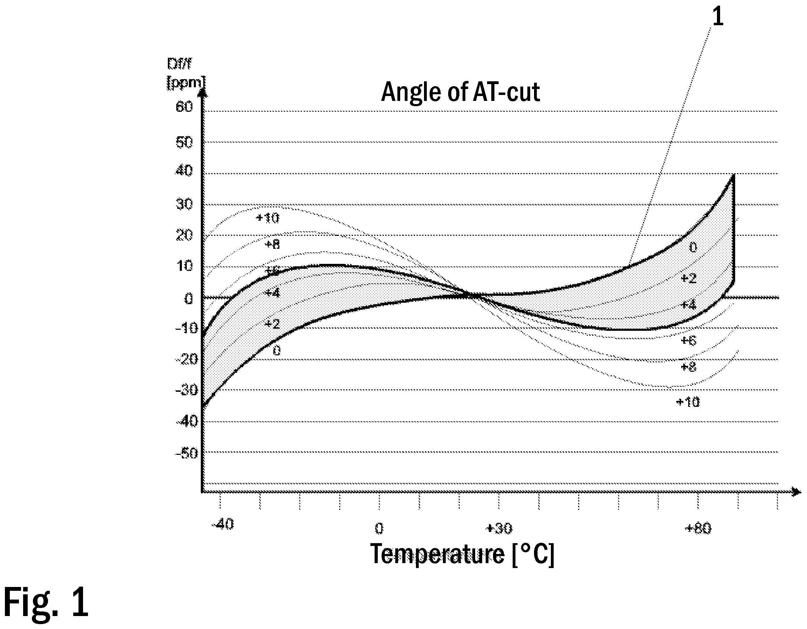

Figure 1 shows a set of frequency-temperature curves of an AT-cut crystal according to the prior art. The set of frequency-temperature curves of the AT-cut crystal shows frequency-temperature curves for AT-cut basic crystals. Each curve represents a cutting angle $\Delta\theta$ in relation to a basic AT cut (e.g. $\theta=35°20'$, $\Phi=0$) and is somewhat of a third-degree polynomial in shape. The temperature coefficient, measured as a frequency deviation ppm (parts per million) in respect of degree Celsius, corresponds to the slope of the curve. The temperature coefficient is zero at two points. These points are the upper and lower turning point, and they fall symmetrically around a point at +20°C ... +30°C. The temperature variations of a prior-art AT-cut crystal depend on the cutting angle of the crystal and are relatively extensive in a conventional quartz crystal.

A problem with the present manufacturing methods of TCXO modules is that due to the precise temperature compensation result, the present manufacturing methods of TCXO modules require temperature variations. Temperature variations require expensive ovens, which adds to the manufacturing time and costs of TCXO modules. In TCXO modules, the temperature compensation function is implemented by an integrated circuit or discrete components with typically rather high manufacturing tolerances. This means that the TXCO module to be made needs to be measured in several temperatures to obtain correct settings for a sufficiently perfect compensation result.

There are known solutions for temperature compensation of oscillators. The prior-art solutions for temperature compensation of oscillators typically comprise an integrated circuit to be attached to an oscillator, such as an external crystal.

US 2013/041859 A1 discloses an integrated circuit for oscillator temperature compensation based an neural networks.

US 2002/105362 A1 relates to an artificial neural network (ANN) comprising differential pairs, particularly to a neuron component and a logistic function as activation function. 11

US 6 484 133 B1 relates to an artificial neural network (ANN) comprising a neural model based on a logistic function used as activation function. 1J

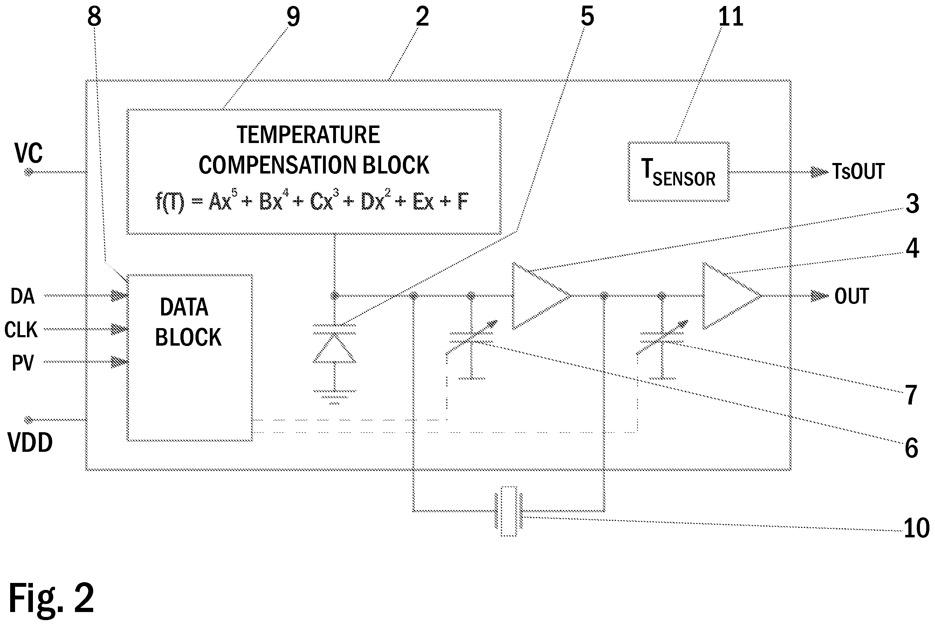

Figure 2 shows a prior-art integrated circuit for oscillator temperature compensation. The prior-art integrated circuit 2 for oscillator temperature compensation comprises amplifiers 3, 4, a varactor diode 5, voltage-controlled capacitances 6, 7, a data block 8, and a temperature compensation block 9. In addition, an external crystal oscillator 10 is connected to the prior-art integrated circuit 2. The prior-art integrated circuit 2 also comprises an internal temperature sensor 11.

A voltage-control inlet VC of the prior-art integrated circuit 2 receives control voltage that is fed through the temperature compensation block 9 to control the reverse voltage acting over the varactor diode 5 and through it the capacitance of the varactor diode 5 and the resonance frequency of the integrated circuit 2 resonance circuit.

In the prior-art integrated circuit 2, it is typical to use as the external crystal oscillator 10 crystals with a known temperature compensation function, such as crystals of specific type with sufficiently small manufacturing tolerances, or crystals that have been measured in various temperatures. Preferably, AT-cut crystals can be used. The error curve of the external crystal oscillator 10 used in the prior-art integrated circuit 2 is typically similar to a third-degree polynomial and, therefore, the temperature compensation is usually also done using polynomials.

A compensation signal produced by the temperature compensation block 9 is summed with the control voltage VC to obtain an actual compensated control voltage. The ambient temperature measurement of the temperature compensation block 9 is made with an internal temperature sensor 11. A resistor or PN junction voltage, without being limited to these, can be used as the internal temperature sensor 11, in which case the output of the temperature sensor 11 is either voltage or current.

The prior-art integrated circuit 2 is calibrated, programmed and controlled through the serial bus of the data block 8. Said serial bus typically comprises a programming inlet PV, serial bus clock inlet CLK, and serial bus data inlet DA.

In the manufacture of prior-art integrated circuits 2, production variations usually need to be calibrated or else the production yield becomes too low. This calibration may be done either during the component testing or the TCXO-module testing. The integrated circuit 2 has an internal temperature sensor 11, the output of which is a temperature-dependent voltage or current. In a calibration situation, temperature changes are modelled by an external voltage or current source that is connected to the output pin TsOUT of the temperature sensor 11. This way, the output TsOUT of the temperature sensor can be forced to a known voltage with the external voltage/current source. The integrated circuit may be calibrated by measuring the compensation curve of its voltage or output frequency with known TsOUT voltages. The necessary settings of the integrated circuit 2 can be estimated by calculating them from these measurements in such a manner that the circuit can be made to match certain parameters of the external crystal oscillator 10.

In the temperature compensation block 9 of the prior-art integrated circuit 2 shown in Figure 2, it is possible to use a fifth-degree polynomial, for instance, for compensating the error caused by temperature:

$$f(T) = Ax^5 + Bx^4 + Cx^3 + Dx^2 + Ex + F.$$

In a typical prior-art solution for oscillator temperature compensation, a sum function of several polynomial functions having different degrees are used.

In prior-art solutions, a problem with the integrated circuit oscillator temperature compensation is the imprecision of the compensation. A drawback with the prior-art temperature compensation method is that polynomials are global functions, in which each observation point affects the entire examination range. In solutions according to the prior-art temperature compensation method, a starting error of ±20 ppm caused by a temperature variation of the oscillator, for example, may even in the best case be compensated to a residual error at an accuracy of ±0.5 ppm (parts per million).

Today, a smaller size than before is required of components used in electronics and telecommunications. At the same time, the oscillators used in electronics and telecommunications need to have a more precise and stable frequency than before. Therefore, oscillators are expected to be significantly more precise in temperature error compensation. The problem is that improving the precision of temperature error compensation also increases the space required by the necessary components on the integrated circuit.

Thus, in electronics and telecommunications technology, there is a clear need and demand for new solutions for oscillator temperature compensation to improve the precision of temperature error compensation without increasing too much the space required by the components used in compensation on the integrated circuit. In addition, there is a clear need and demand for new temperature-compensated oscillators in order to achieve a better than before precision of temperature error compensation.

**Brief description of the invention**

It is an object of the present invention to provide a novel type of solution for oscillator temperature compensation, with which the precision of the temperature error compensation can be improved. Another object of the present invention is to provide a novel type of solution for a temperature-compensated oscillator, with which an improved precision is achieved for temperature error compensation.

The method of the invention of oscillator temperature compensation is defined in claim 1.

Preferably, the method also comprises a step for calibrating a temperature error in the temperature range to be used.

The integrated circuit for oscillator temperature compensation of the invention is defined in claim 3.

Preferably, said integrated circuit comprises an external voltage or current source connected to the outlet pin TsOUT of said temperature sensor for the purpose of modelling temperature changes.

The temperature-compensated oscillator unit of the invention that comprises an integrated circuit of the invention and an oscillator is characterised in that said oscillator has a known temperature compensation function.

.

The present invention provides several advantages, which will be better understood from reading the detailed description. A better than before precision for temperature error compensation is achieved with the oscillator temperature compensation solution of the invention.

### Brief description of the figures

Figure 1 shows a set of frequency-temperature curves of a prior-art AT-cut crystal,

Figure 2 shows a prior-art integrated circuit for oscillator temperature compensation,

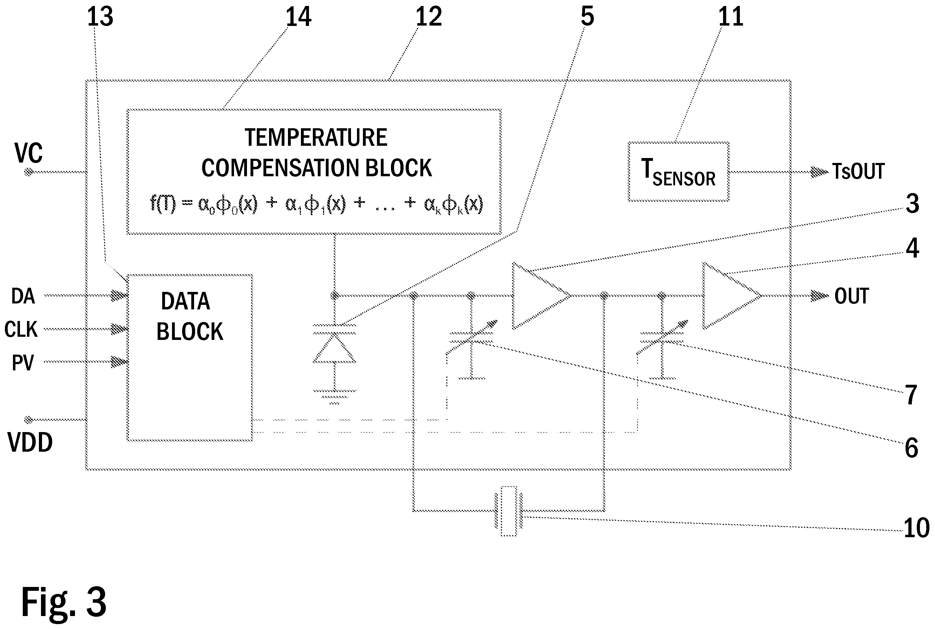

Figure 3 shows an integrated circuit for oscillator temperature compensation according to the invention,

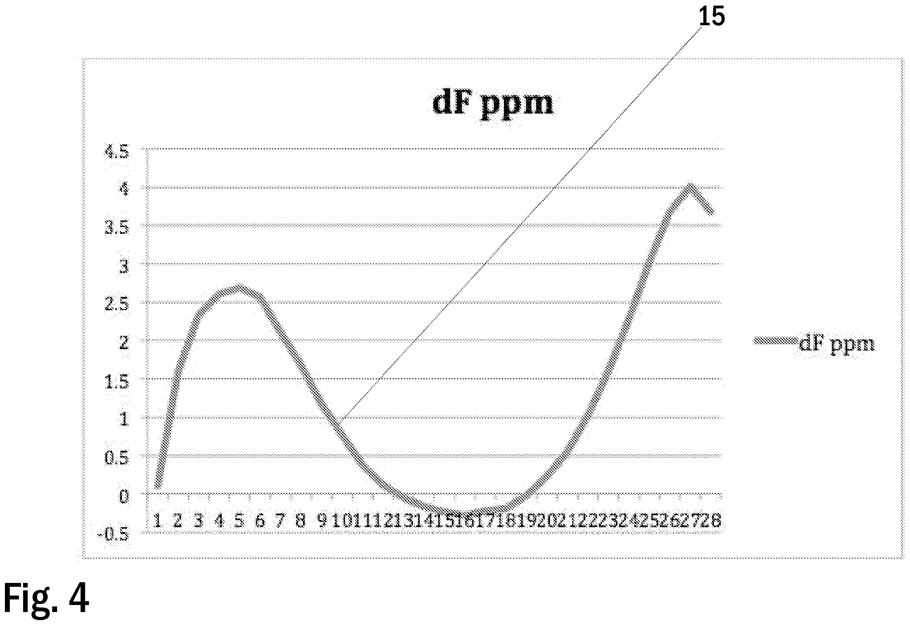

Figure 4 shows an oscillator temperature error curve to be compensated in accordance with an unclaimed comparative example,

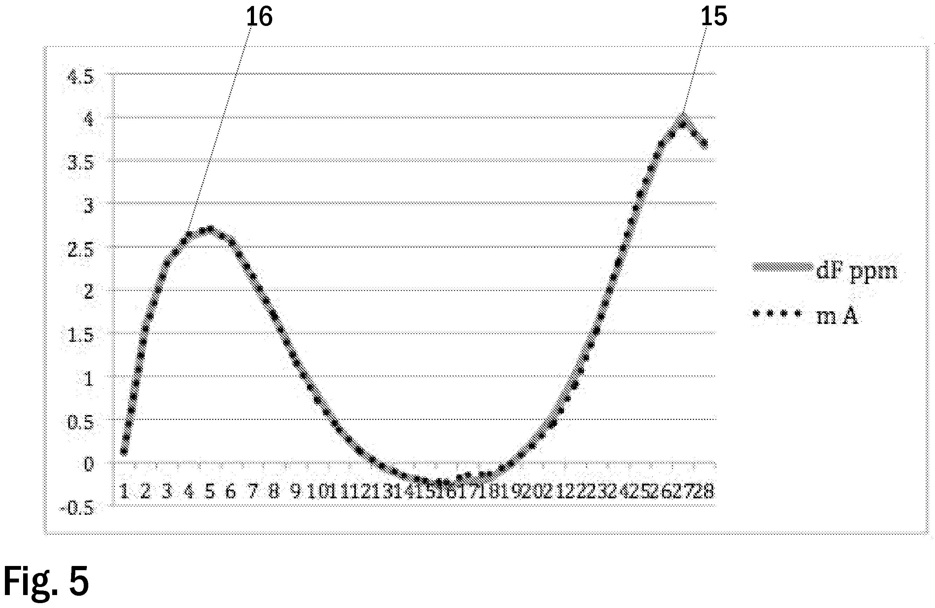

Figure 5 shows an oscillator temperature error compensation curve according to an unclaimed comparative example,

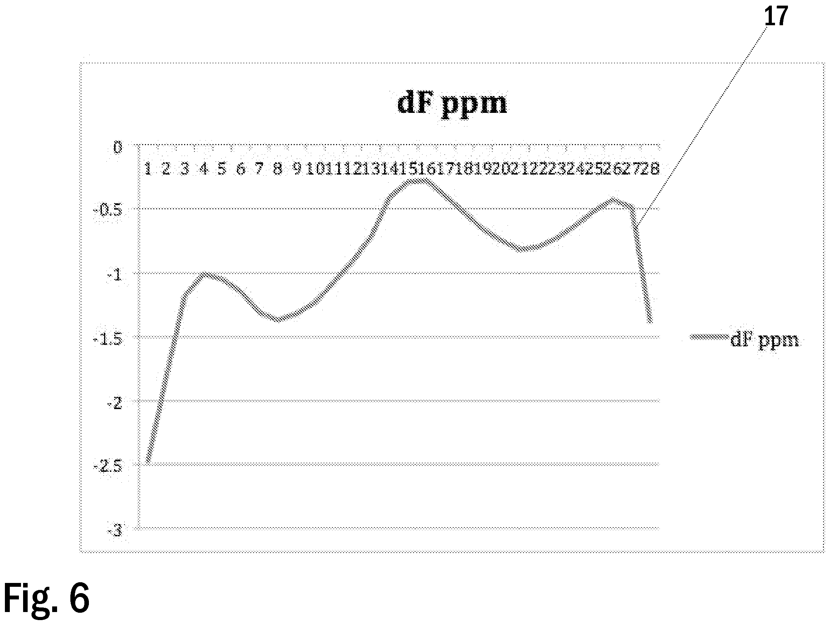

Figure 6 shows an alternative oscillator temperature error curve to be compensated in accordance with an unclaimed comparative example,

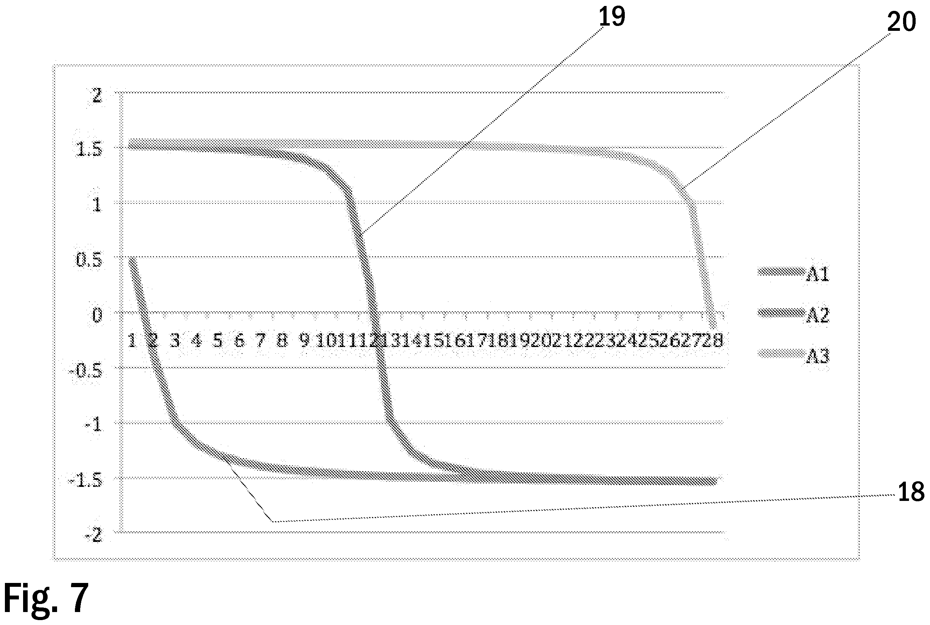

Figure 7 shows local basis function graphs of an alternative oscillator temperature error compensation according to an unclaimed comparative example,

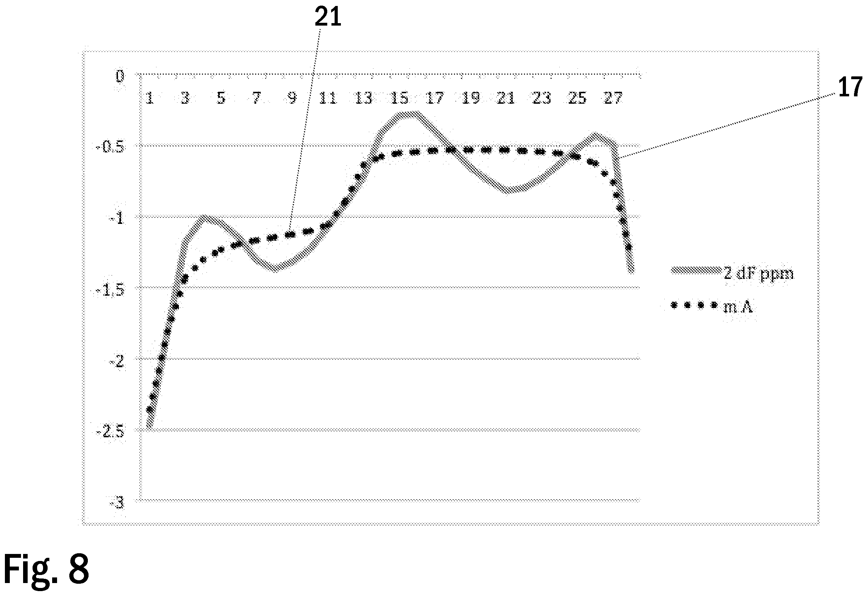

Figure 8 shows an alternative oscillator temperature error compensation curve according to an unclaimed comparative example,

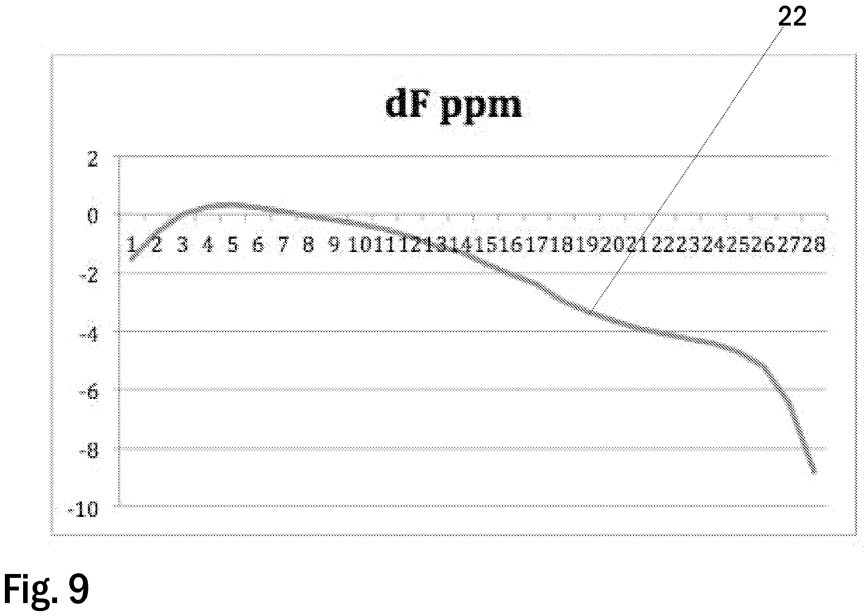

Figure 9 shows another alternative oscillator temperature error curve to be compensated in accordance with an unclaimed comparative example,

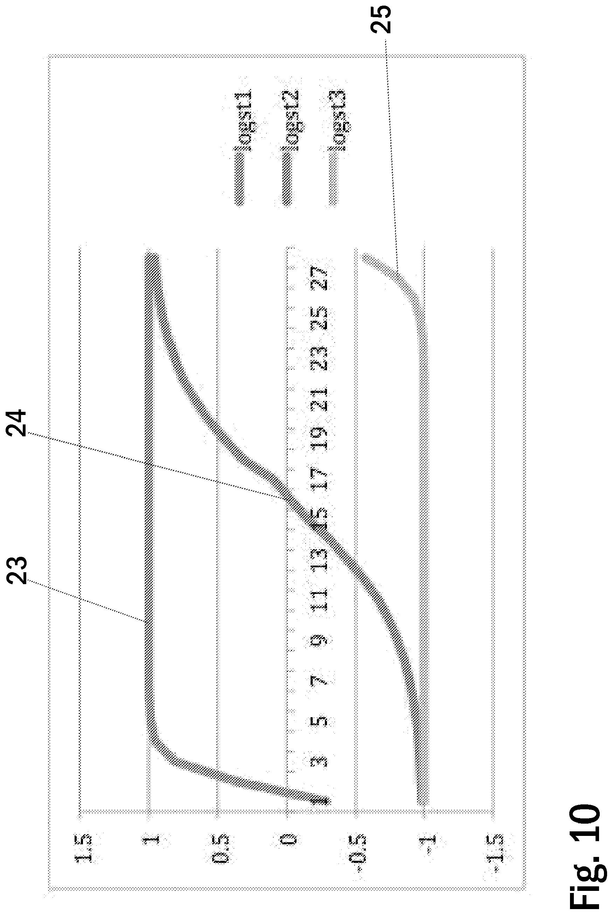

Figure 10 shows local basis function graphs of another alternative oscillator temperature error compensation according to the invention,

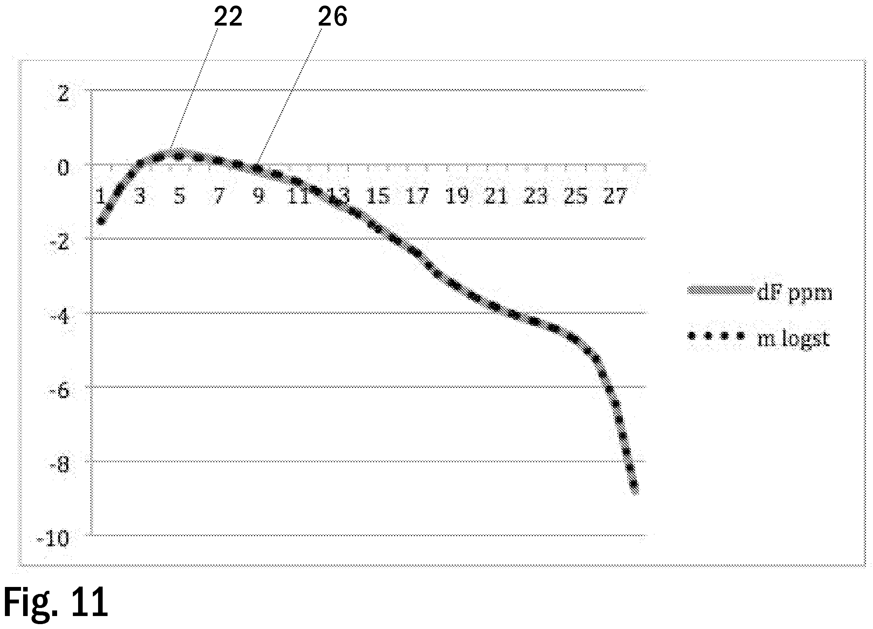

Figure 11 shows another alternative oscillator temperature error compensation curve according to the invention.

Figures 1 to 2 have been presented above. Some comparative examples will now be described in greater detail in the context of some preferred embodiments with reference to Figures 3 to 9. Embodiments of the invention will be described in the context of Fig. 10 and 11.

### Detailed description of an embodiment of the invention

In an oscillator temperature compensation solution of the invention, the idea is to utilise a sum function consisting of local compensation basis functions in oscillator temperature error compensation.

The sum function $f(T)$ of the oscillator temperature error compensation can be as follows:

$$f(T) = \alpha_0 \phi_0(x) + \alpha_1 \phi_1(x) + \cdots + \alpha_k \phi_k(x),$$

where $\phi_0 \equiv 1$ and where the local compensation basis functions $\phi_j, j = 0, \ldots, k$ are linearly independent and form a subspace $M$ base.

According to the basics of linear algebra, all traditional functions, such as exponential functions, sine and cosine functions as well as arc functions, may serve as subspace basis functions. Further, of the subspace basis functions at least the arc tangent function, logistic function, polynomial function, and hyperbolic tangent function may serve as local compensation basis functions.

Figure 3 shows an integrated circuit for oscillator temperature compensation according to the invention. The integrated circuit 12 for oscillator temperature compensation according to the invention comprises amplifiers 3, 4, a varactor diode 5, voltage-controlled capacitances 6, 7, a data block 13, and a temperature compensation block 14. In addition, an oscillator 10 is connected to the integrated circuit 12 of the invention. The integrated circuit 12 of the invention also comprises an internal temperature sensor 11.

A voltage-control inlet VC of the integrated circuit 12 according to the invention receives a control voltage that is fed through the temperature compensation block 14 to control the reverse voltage acting over the varactor diode 5 and through it the capacitance of the varactor diode 5 and the resonance frequency of the integrated circuit 12 resonance circuit.

In the integrated circuit 12 of the invention, it is possible to use as the oscillator 10 crystals with a known required temperature compensation function, such as crystals of certain type with sufficiently low manufacturing tolerances, or crystals that have been measured in various temperatures. The invention encompasses to use AT-cut crystal oscillators.

In the integrated circuit 12 according to the invention, a sum function consisting of local compensation basis functions are utilised in the temperature compensation block 14 for oscillator temperature error compensation.

The sum function $f(T)$ of the oscillator temperature error compensation according to the invention can be as follows:

$$f(T) = \alpha_0\phi_0(x) + \alpha_1\phi_1(x) + \cdots + \alpha_k\phi_k(x),$$

where $\phi_0 \equiv 1$ and where the local compensation basis functions $\phi_j, j = 0, \ldots, k$ are linearly independent and form a subspace $M$ base.

In the temperature compensation block 14, a compensation signal provided by the temperature error compensation sum function $f(T)$ is summed with the control voltage VC to obtain an actual compensated control voltage. The ambient temperature measurement of the temperature compensation block 14 is made with the internal temperature sensor 11. A resistor or PN junction voltage, without being limited to these, can be used as the internal temperature sensor 11, in which case the output of the temperature sensor 11 is either voltage or current.

The integrated circuit 12 of the invention is calibrated, programmed, and controlled through the bus of the data block 13. Said bus comprises at least a programming inlet PV, bus clock inlet CLK, and bus data inlet DA.

In the manufacture of integrated circuits 12 according to the invention, production variations usually need to be calibrated or else the production yield becomes too low. This calibration may be done either during the component testing or the TCXO module testing. The integrated circuit 12 has an internal temperature sensor 11, the output of which is a temperature-dependent voltage or current. In a calibration situation, temperature changes are modelled by an external voltage or current source that is connected to the output pin TsOUT of the temperature sensor 11. This way, the output TsOUT of the temperature sensor can be forced to a known voltage with the external voltage/current source. The integrated circuit may be calibrated by measuring the compensation curve of its voltage or output frequency with known TsOUT voltages. The necessary settings of the integrated circuit 12 can be compensated by calculating compensated values from the temperature error curve obtained by measurements by means of the oscillator temperature error compensation sum function $f(T)$ in such a manner that the circuit can be made to match with specific oscillator 10 parameters. This way, the temperature error compensation of the invention can be implemented at one temperature.

In the solution of the invention, the temperature offset of the integrated circuit 12 can be calibrated, for instance, by measuring the compensation curve of the integrated circuit 12 with five TsOUT voltage values. In the solution of the invention, the integrated circuit 12 comprises an internal digital-to-analog converter (DAC), which internal DAC produces a linear tuning range for temperature calibration.

In the solution of the invention, the compensation amplification of the integrated circuit 12 can be similarly calibrated. The calibration can be performed by measuring the output frequency at two known points, for instance. The frequency difference between these two points is then subtracted from a desired value or a default value that depends on the oscillator 10. In the solution of the invention, the calibration of the TCXO module does not require other calculations or temperature variations. This means that the TCXO module can be made without ovens, which shortens production time and reduces production costs.

The solution of the invention for oscillator temperature compensation can be used in the temperature compensation of different crystal oscillators.

In the integrated circuit of the invention, temperature compensation for the oscillator can be implemented by means of differential pairs. The use of differential pairs in integrated circuits is for instance described in the article: "A current driven, programmable gain differential pair using MOS translinear circuits; Massimo Conti et al.", published in conference publication "ISCAS '98 Proceedings of the 1998 IEEE International Symposium on Circuits and Systems on 31 May-3 June 1998 in Monterey, CA, USA" (see "http://www.deit.univpm.it/~sim/publications/MCon98CDP.pdf"). Said publication describes a current-controlled MOS differential pair, the outlet of which follows the quasi-sigmoidal rule. The described MOS differential pair utilises the translinear principle and the angular coefficient of its outlet can be programmed by adjusting one of the control currents. The shape of the sigmoidal inlet-outlet function can be adapted over a wide usage range by adjusting the current.

In the integrated circuit of the invention, temperature compensation for the oscillator is implemented by means of differential pairs. In the temperature compensation solution of the invention, voltage- and/or current-controlled differential are used.

For the temperature error curve compensation performed in Figure 3 in the temperature compensation block 14 of the integrated circuit 12 according to the invention, it is possible to use the oscillator temperature error compensation sum function $f(T)$, which can be presented as follows:

$$f(T) = \alpha_0\phi_0(x) + \alpha_1\phi_1(x) + \cdots + \alpha_k\phi_k(x),$$

where $\phi_0 \equiv 1$ and where the local compensation basis functions $\phi_j, j = 0, \dots, k$ are linearly independent and form a subspace $M$ base.

In oscillator temperature compensation solutions, it is possible to use as the local compensation basis functions $\phi_j, j = 0, \dots, k$ arc tangent functions, polynomial functions and/or hyperbolic tangent functions, for instance. According to the invention, logistic functions are used.

Of these local compensation basis functions $\phi_j, j = 0, \dots, k,$ the arc tangent function can be presented as follows:

$$A(x) = \frac{2}{\pi} arctan(a_1 + a_2x),$$

where $a_1$ and $a_2$ are observation parameters and the inflection point $x_{inf}$ of the function is $\left(-\frac{a_1}{a_2}, 0\right)$.

Correspondingly, the logistic function can be presented as follows:

$$L(x) = -1 + \frac{2}{1+e^{(b_1+b_2x)}},$$

where $b_1$ and $b_2$ are observation parameters and the inflection point of the function is $\left(-\frac{b_1}{b_2}, 0\right)$.

Further, the polynomial function can correspondingly be presented as follows:

$$P(x) = \frac{c_1+c_2x}{\sqrt{1+(c_1+c_2x)^2}},$$

where $c_1$ and $c_2$ are observation parameters and the inflection point of the function is $\left(-\frac{c_1}{c_2}, 0\right)$.

Further, the hyperbolic tangent function can correspondingly be presented as follows:

$$H(x) = tanh(d_1 + d_2x),$$

where $d_1$ and $d_2$ are observation parameters and the inflection point of the function is $\left(-\frac{d_1}{d_2}, 0\right)$.

In the method of the invention for oscillator temperature compensation, the measurements of the performed series of measurements are divided into at least three local measuring ranges. Next, an initial value for the sum function $f(T)$ of temperature error compensation is established by setting local basis functions and their observation parameter initial values for each of the at least three local measuring ranges. Finally, said initial value of the temperature error compensation sum function $f(T)$ is iterated at least three times one local basis function at a time, after which the temperature error compensation sum function $f(T)$ is obtained.

Figure 4 shows an oscillator temperature error curve to be compensated in accordance with an unclaimed comparative example, The oscillator temperature error curve 15 of said unclaimed comparative example, is based on a series of measurements performed on a crystal oscillator and having 28 measurements made at regular 5°C intervals within the measuring range of -44.5°C to +90.5°C. In the temperature error curve 15 of Figure 4, the horizontal axis of the coordinate system shows the sequence number of the measurement in the series of measurements instead of the correct measuring data.

In the method for oscillator temperature compensation of said unclaimed comparative example, the measurements of the performed series of measurements are divided into local measuring ranges as follows:

area1: (-44.5°C to -22.0°C; 5 measuring points),
area2: (-21.99°C to 32.99°C; 11 measuring points),
area3: (33.0°C to 82.99°C; 10 measuring points), and
area4: (83.0°C to 90.5°C; 2 measuring points).

Next, local basis functions are set as arc tangent functions for each local measuring range as follows:

$$A_j(x) = \frac{2}{\pi} arctan(a_1 + a_2 x),$$

where $j = 0, \dots , 4$, where $a_1$ and $a_2$ are observation parameters and the inflection point of the function $x_{inf}$ is $\left(-\frac{a_1}{a_2}, 0\right)$.

Next, the initial values of the local basis function observation parameters are set as follows:

$A_1$:

$$a_1 = -5 \text{ and } a_2 = -0.1, \text{ so } x_{inf} = -50°C,$$

A2:

$$a_1 = -0.5 \text{ and } a_2 = -0.1, \text{ so } x_{inf} = -5°C,$$

$A_3$:

$$a_1 = 5 \text{ and } a_2 = -0.1, \text{ so } x_{inf} = 50°C,$$

A4:

$$a_1 = 9.5 \text{ and } a_2 = -0.1, \text{ so } x_{inf} = 95°C.$$

Finally, the local basis functions are iterated at least once one basis function at a time, whereby local compensation basis functions are obtained as follows:

$$A_1(x) = arctan(-4.88 - 0.093x), \text{ so } x_{inf} = -52.5°C,$$

$$A_2(x) = arctan(-0.54 - 0.052x), \text{ so } x_{inf} = -10.5°C,$$

$$A_3(x) = arctan(5.03 - 0.070x), \text{ so } x_{inf} = +71.5°C,$$

$$A_4(x) = arctan(10.66 - 0.12x), \text{ so } x_{inf} = +92.7°C.$$

Thus, the following is obtained as the temperature error compensation sum function $f(T)$:

$$f(T) = -4.96 - 6.44A_1(x) - 2.78A_2(x) - 2.73A_3(x) + 1.36A_4(x).$$

Figure 5 shows an oscillator temperature error compensation curve according to another unclaimed comparative example. The oscillator temperature error curve to be compensated in accordance with said other unclaimed comparative example is numbered with reference number 15. The compensation curve according to the temperature error compensation sum function $f(T) = -4.96 - 6.44A_1(x) - 2.78A_2(x) - 2.73A_3(x) + 1.36A_4(x)$ is numbered with reference number 16.

In the oscillator temperature compensation solution according to said other unclaimed comparative example, the square of the total deviation $\Delta^2_A = 0.07$ is obtained with the fourth-degree *arctan* model shown in Figure 5. Correspondingly, with the sixth-degree polynomial adaptation, the square of the total deviation is $\Delta^2_{6p} = 0.21$. Temperature compensation implemented by the *arctan* model is, thus, significantly better than other known solutions

Figure 6 shows an alternative oscillator temperature error curve to be compensated in accordance with yet another unclaimed comparative example. The oscillator temperature error curve 17 to be compensated in accordance with said other unclaimed comparative example is based on a series of measurements performed on a crystal oscillator and having 28 measurements made at regular 5°C intervals within the measuring range of -44.5°C to +90.5°C. In the temperature error curve 17 of Figure 6, the horizontal axis of the coordinate system shows the sequence number of the measurement in the series of measurements instead of the correct measuring data.

With the second alternative oscillator temperature error curve 17 to be compensated, good compensation would require a sixth-degree basis function model, because the temperature error curve 17 of the measuring results has six ascending and descending phases. For compensating the temperature error curve 17 of Figure 6, we will, however, select a clearly lower-degree model so as to obtain a better picture of the differences in the estimation with basis functions in comparison with polynomial estimation. In the second alternative method for oscillator temperature compensation, the measurements of the performed series of measurements are divided into three local measuring ranges.

Next, local basis functions are set as arc tangent functions for each local measuring range as follows:

$$A_j(x) = \frac{2}{\pi} arctan(a_1 + a_2 x),$$

where j = 0, ..., 4, where $a_1$ and $a_2$ are observation parameters and the inflection point $x_{inf}$ of the function is $\left(-\frac{a_1}{a_2}, 0\right)$.

Next, the initial values of the local basis function observation parameters are set as follows:

$A_1$:

$$a_1 = -5 \text{ and } a_2 = -0.1 \;\; x_{inf} = -50°C,$$

$A_2$:

$$a_1 = 2 \text{ and } a_2 = -0.1, \text{ so } x_{inf} = 20°C,$$

$A_3$:

$$a_1 = 9 \text{ and } a_2 = -0.1, \text{ so } x_{inf} = 90°C.$$

Finally, the local basis functions are iterated at least once one basis function at a time, whereby local compensation basis functions are obtained as follows:

$$A_1(x) = arctan(-8.75 - 0.21x), \text{ so } x_{inf} = -41.8°C,$$

$$A_2(x) = arctan(3.86 - 0.35x), \text{ so } x_{inf} = +10.9°C,$$

$$A_3(x) = arctan(29.6 - 0.33x), \text{ so } x_{inf} = +89.8°C.$$

Thus, the following is obtained as the temperature error compensation sum function $f(T)$:

$$f(T) = -2.505 - 0.635A_1(x) - 0.197A_2(x) + 0.477A_3(x).$$

Figure 7 shows local basis function graphs of an alternative oscillator temperature error compensation . In Figure 7, the graph of a local basis function $A_1$ of temperature error compensation is numbered with reference number 18. Correspondingly, the graph of a local basis function $A_2$ is numbered with reference number 19. Further, the graph of a local basis function $A_3$ is numbered with reference number 20. As Figure 7 shows, the local basis functions $A_1$, $A_2$, and $A_3$ are only active on a narrow section of the measuring range.

Figure 8 shows an alternative oscillator temperature error compensation curve. The alternative oscillator temperature error curve to be compensated is numbered with reference number 17. The compensation curve according to the sum function $f(T) = -2.505 - 0.635A_1(x) - 0.197A_2(x) + 0.477A_3(x)$ of the temperature error compensation is numbered with reference number 21.

In the alternative oscillator temperature compensation solution according to the invention, the square of the total deviation $\Delta^2_A = 0.89$ is obtained with the third-degree *arctan* model shown in Figure 8. Correspondingly, with a fourth-degree polynomial adaptation, the square of the total deviation is $\Delta^2_{4p} = 2.16$. Temperature compensation implemented by the *arctan* model is, thus, significantly more precise than other known solutions

Figure 9 shows a second alternative oscillator temperature error curve to be compensated The oscillator temperature error curve 22 to be compensated is based on a series of measurements performed on a crystal oscillator and having 28 measurements made at regular 5°C intervals within the measuring range of -44.5°C to +90.5°C. In the temperature error curve 22 of Figure 9, the horizontal axis of the coordinate system shows the sequence number of the measurement in the series of measurements instead of the correct measuring data.

In this case, the measurements of the performed series of measurements are divided into local measuring areas as follows:

area1: (-44.5°C to -27.0°C; 4 measuring points),
area2: (-26.99°C to +77.99°C; 21 measuring points), and
area3: (+78.0°C to +90.5°C; 3 measuring points).

For the compensation of the alternative oscillator temperature error curve 22 of the invention, we will now select as the local compensation basis functions logistic functions so as to get an idea of the differences in the estimation with logistic basis functions in comparison with polynomial estimation.

Next, local basis functions are set as logistic functions for each local measuring range as follows:

$$L(x) = -1 + \frac{2}{1 + e^{(b_1 + b_2 x)}},$$

where $b_1$ and $b_2$ are observation parameters and the inflection point of the function is $\left(-\frac{b_1}{b_2}, 0\right)$.

Next, the initial values of the local basis function observation parameters are set as follows:

$L_1$:

$$b_1 = -5 \text{ and } b_2 = -0.1, \text{ so } x_{inf} = -50°C,$$

$L_2$:

$$b_1 = 2 \text{ and } b_2 = -0.1, \text{ so } x_{inf} = 20°C,$$

$L_3$:

$$b_1 = 9 \text{ and } b_2 = -0.1, \text{ so } x_{inf} = 95°C.$$

Finally, the local basis functions are iterated at least once one basis function at a time, whereby local compensation basis functions are obtained as follows:

$$L_1(x) = -1 + \frac{2}{1+e^{(-12.5-0.295x)}}, \text{ so } x_{inf} = -42.4°C,$$

$$L_2(x) = -1 + \frac{2}{1+e^{(1.95-0.065x)}}, \text{ so } x_{inf} = +30.0°C,$$

$$L_3(x) = -1 + \frac{2}{1+e^{(18.5-0.19x)}}, \text{ so } x_{inf} = +97.4°C.$$

Thus, the following is obtained as the temperature error compensation sum function $f(T)$:

$$f(T) = -13.5 + 1.44L_1(x) - 2.52L_2(x) - 9.87L_3(x).$$

Figure 10 shows local basis function graphs of another alternative oscillator temperature error compensation according to the invention. In Figure 10, the graph of a local basis function $L_1$ of temperature error compensation is numbered with reference number 23. Correspondingly, the graph of a local basis function $L_2$ is numbered with reference number 24. Further, the graph of a local basis function $L_3$ is numbered with reference number 25. As Figure 10 shows, the local basis functions $L_1$, $L_2$, and $L_3$ are only active on a narrow section of the measuring range.

Figure 11 shows a second alternative oscillator temperature error compensation curve according to the invention. The second alternative oscillator temperature error curve to be compensated in accordance with the invention is numbered with reference number 22. The compensation curve of the sum function $f(T) = -13.5 + 1.44L_1(x) - 2.52L_2(x) - 9.87L_3(x)$ of the temperature error compensation is numbered with reference number 26.

In the second alternative oscillator temperature compensation solution according to the invention, the square of the total deviation $\Delta^2 = 0.060$ is obtained with the third-degree logistic function model shown in Figure 11, and this temperature compensation is significantly more precise than corresponding known solutions.

Radial basis functions can also be used in the solution of the invention. In the solution of the invention, the local radial compensation basis function $\phi_j, j = 0, \ldots, k$ can then be presented as follows:

$$\phi(x) = e^{-\frac{(x-u)^2}{v}},$$

where $u$ is the maximum point of the local radial basis function and $v$ is the width of the graph.

The solution of the invention for oscillator temperature compensation is used in the temperature compensation of At-cut crystal oscillators. By means of the oscillator temperature compensation solution of the invention, it is possible to improve the precision of the oscillator temperature error compensation used in electronics and telecommunications technology. The new temperature-compensated oscillators of the invention are thus significantly more precise than the earlier oscillators over the entire temperature range used.

It is apparent to a person skilled in the art that as technology advances, the basic idea of the invention may be implemented in many different ways. The invention and its embodiments are thus not restricted to the examples described above but may vary within the scope of the claims.

**Claims**

1.  A method of oscillator temperature compensation in a temperature compensation block (14) of an integrated circuit (12) for at least one AT-cut crystal oscillator (10), said integrated circuit (12) comprising several voltage- and/or current-controlled differential pairs for implementing temperature compensation in the oscillator (10), which method comprises:

setting local compensation basis functions $\phi_j, j = 0, \ldots, k$ as logistic functions $L(x)$

$$= -1 + \frac{2}{1+e^{(b_1+b_2 x)}},$$ where $b_1$ and $b_2$ are observation parameters and the inflection point of the function is $\left(-\frac{b_1}{b_2}, 0\right)$, wherein k is the number of local temperature measuring ranges, and
calibrating said temperature compensation block (14) in the temperature range to be used, wherein:

> the measurements of a performed series of measurements are divided into at least three local temperature measuring ranges:
> a sum function $f(T)$ of the oscillator temperature error compensation is $f(T) = \alpha_0 \phi_0(x) + \alpha_1 \phi_1(x) + \cdots + \alpha_k \phi_k(x)$, where $\phi_0 \equiv 1$ and where the local compensation basis functions $\phi_j, j = 0, \ldots, k$ are linearly independent and form a subspace $M$ base,
> an initial value for the sum function $f(T)$ of temperature error compensation is established by setting local basis functions and their observation parameter initial values for each of the at least three local measuring ranges, and
> said initial value of the temperature error compensation sum function $f(T)$ is iterated at least three times one local basis function at a time, after which the temperature error compensation sum function $f(T)$ is obtained.

2. A method as claimed in claim 1, **characterised in that** it also comprises a step for calibrating a temperature error in the temperature range to be used.

3. An integrated circuit (12) for oscillator temperature compensation, comprising a temperature compensation block (14) having local compensation basis functions $\phi_j, j = 0, \ldots, k$ for at least one AT-cut crystal oscillator (10), an internal temperature sensor (11) and a data block (13) for calibrating said temperature compensation block (14) in the temperature range to be used, and several voltage- and/or current-controlled differential pairs, with which said integrated circuit (12) is configured to implement a method of any one of the claims 1 to 2.

4. An integrated circuit (12) as claimed in claim 3, **character- ised** in that said integrated circuit (12) comprises an external voltage or current source connected to the outlet pin TsOUT of said temperature sensor (11) for the purpose of modelling temperature changes.

5. A temperature-compensated oscillator unit that comprises an integrated circuit (12) of any one of claims 3 to 4 and an oscillator (10), **char- acterised** in that said oscillator (10) has a known temperature compensation function.

**Patentansprüche**

1. Verfahren zur Oszillatortemperaturkompensation in einem Temperaturkompensationsblock (14) einer integrierten Schaltung (12) für mindestens einen AT-Schnitt-Kristalloszillator (10), wobei die integrierte Schaltung (12) mehrere spannungs- und/oder stromgesteuerte Differentialpaare zum Implementieren von Temperaturkompensation in dem Oszillator (10) umfasst, wobei das Verfahren Folgendes umfasst:

> Einstellen lokaler Kompensationsbasisfunktionen $\phi_j, j = 0, \ldots, k$ als logistische Funktionen
>
> $$L(x) = -1 + \frac{2}{1+e^{(b_1+b_2 x)}},$$ wo $b_1$ und $b_2$ Beobachtungsparameter sind und der Wendepunkt der Funk-
>
> tion $\left(-\frac{b_1}{b_2}, 0\right)$ ist, wobei k die Anzahl lokaler Temperaturmessbereiche ist, und Kalibrieren des Temperaturkompensationsblocks (14) in dem zu verwendenden Temperaturbereich, wobei:
> die Messungen einer durchgeführten Reihe von Messungen in mindestens drei lokale Temperaturmessbereiche unterteilt werden,
> eine Summenfunktion $f(T)$ der Oszillatortemperatur-Fehlerkompensation $f(T) = \alpha_0 \phi_0(x) + \alpha_1 \phi_1(x) + \cdots + \alpha_k \phi_k(x)$ ist, wo $\phi_0 \equiv 1$ und wo die lokalen Kompensationsbasisfunktionen $\phi_j, j = 0, \ldots, k$ linear unabhängig sind und eine Basis des Unterraums M bilden,

ein Ausgangswert für die Summenfunktion $f(T)$ der Temperaturfehlerkompensation durch Einstellen lokaler Basisfunktionen und ihrer Beobachtungsparameter-Ausgangswerte für jeden von den mindestens drei lokalen Messbereichen bestimmt wird, und

der Ausgangswert der Temperaturfehlerkompensationssummenfunktion $f(T)$ mindestens drei Mal jeweils eine lokale Basisfunktion iteriert wird, wonach die Temperaturfehlerkompensationssummenfunktion $f(T)$ erhalten wird.

2. Verfahren nach Anspruch 1, **dadurch gekennzeichnet, dass** es auch einen Schritt zum Kalibrieren eines Temperaturfehlers im zu verwendenden Temperaturbereich umfasst.

3. Integrierte Schaltung (12) zur Oszillatortemperaturkompensation, die einen Temperaturkompensationsblock (14) umfasst, der lokale Kompensationsbasisfunktionen $\phi_j, j = 0, ... , k$ für mindestens einen AT-Schnitt-Kristalloszillator (10) aufweist, einen inneren Temperatursensor (11) und einen Datenblock (13) zum Kalibrieren des Temperaturkompensationsblocks (14) im zu verwendenden Temperaturbereich und mehrere spannungs- und/oder stromgesteuerte Differentialpaare umfasst, mit denen die integrierte Schaltung (12) dazu ausgestaltet ist, ein Verfahren nach einem der Ansprüche 1 bis 2 zu implementieren.

4. Integrierte Schaltung (12) nach Anspruch 3, **dadurch gekennzeichnet, dass** die integrierte Schaltung (12) eine externe Spannungs- oder Stromquelle umfasst, die zum Zweck des Modellierens von Temperaturänderungen mit dem Ausgangspin TsOUT des Temperatursensors (11) verbunden ist.

5. Temperaturkompensierte Oszillatoreinheit, die eine integrierte Schaltung (12) nach einem der Ansprüche 3 bis 4 und einen Oszillator (10) umfasst, **dadurch gekennzeichnet, dass** der Oszillator (10) eine bekannte Temperaturkompensationsfunktion aufweist.

## Revendications

1. Procédé de compensation de température d'oscillateur dans un bloc de compensation de température (14) d'un circuit intégré (12) pour au moins un oscillateur (10) à cristaux de coupe AT, ledit circuit intégré (12) comprenant plusieurs paires différentielles commandées par tension et/ou par courant pour mettre en oeuvre une compensation de température dans l'oscillateur (10), ledit procédé comprend :

le réglage de fonctions de base locale de compensation $\phi_j, j = 0, ... , k$ en tant que fonctions logistiques

$$L(x) = -1 + \frac{2}{1+e^{(b_1+b_2 x)}}$$ , où $b_1$ et $b_2$ sont des paramètres d'observation et le point d'inflexion de la fonction est $\left(-\frac{b_1}{b_2}, 0\right)$ , où k est le nombre de plages de mesure locales de température, et

l'étalonnage dudit bloc de compensation de température (14) dans la plage de température à utiliser, dans lequel :

les mesures d'une série de mesures réalisée sont divisées en au moins trois plages de mesure locales de température,

une fonction de somme $f(T)$ de la compensation d'erreur de température d'oscillateur est $f(T) = \alpha_0\phi_0(x) + \alpha_1\phi_1(x) + \cdots + \alpha_k\phi_k(x)$, où $\phi_0 \equiv 1$ et où les fonctions de base locale de compensation $\phi_j, j = 0, ... , k$ sont linéairement indépendantes et forment une base $M$ de sous-espace,

une valeur initiale pour la fonction de somme $f(T)$ de compensation d'erreur de température est établie en réglant des fonctions de base locale et leurs valeurs initiales de paramètre d'observation pour chacune des au moins trois plages de mesure locales, et

ladite valeur initiale de la fonction de somme $f(T)$ de compensation d'erreur de température est itérée au moins trois fois une fonction de base locale à la fois, après quoi la fonction de somme $f(T)$ de compensation d'erreur de température est obtenue.

2. Procédé selon la revendication 1, **caractérisé en ce qu'**il comprend également une étape pour étalonner une erreur de température dans la plage de température à utiliser.

3. Circuit intégré (12) pour une compensation de température d'oscillateur, comprenant un bloc de compensation de température (14) présentant des fonctions de base locale de compensation $\phi_j$ $j$ = **0, ... , $k$** pour au moins un oscillateur (10) à cristaux de coupe AT, un capteur de température (11) interne et un bloc de données (13) pour étalonner ledit bloc de compensation de température (14) dans la plage de température à utiliser, et plusieurs paires différentielles commandées par tension et/ou par courant, avec lesquels ledit circuit intégré (12) est configuré pour mettre en oeuvre un procédé selon l'une quelconque des revendications 1 à 2.

4. Circuit intégré (12) selon la revendication 3, **caractérisé en ce que** ledit circuit intégré (12) comprend une source de tension ou de courant externe reliée à la broche de sortie TsOUT dudit capteur de température (11) dans le but de modéliser des changements de température.

5. Unité d'oscillateur compensée par la température qui comprend un circuit intégré (12) selon l'une quelconque des revendications 3 à 4 et un oscillateur (10), **caractérisé en ce que** ledit oscillateur (10) présente une fonction de compensation de température connue.

Fig. 1

EP 3 158 644 B1

TsOUT

OUT

T$_{SENSOR}$

11

5

2

9

8

3

4

7

6

10

**TEMPERATURE COMPENSATION BLOCK**

$f(T) = Ax^5 + Bx^4 + Cx^3 + Dx^2 + Ex + F$

**DATA BLOCK**

VC

DA

CLK

PV

VDD

# Fig. 2

**VC**

**TEMPERATURE COMPENSATION BLOCK**

$$f(T) = \alpha_0\phi_0(x) + \alpha_1\phi_1(x) + \ldots + \alpha_k\phi_k(x)$$

$T_{SENSOR}$ — TsOUT

**DA**

**CLK**

**PV**

**DATA BLOCK**

— OUT

**VDD**

**Fig. 3**

EP 3 158 644 B1

Fig. 4

EP 3 158 644 B1

Fig. 5

EP 3 158 644 B1

Fig. 6

EP 3 158 644 B1

Fig. 7

EP 3 158 644 B1

Fig. 8

EP 3 158 644 B1

Fig. 9

Fig. 10

Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013041859 A1
- US 2002105362 A1
- US 6484133 B1

**Non-patent literature cited in the description**

- **MASSIMO CONTI et al.** A current driven, programmable gain differential pair using MOS translinear circuits. *conference publication "ISCAS '98 Proceedings of the 1998 IEEE International Symposium on Circuits and Systems,* 31 May 1998